Europäisches Patentamt

European Patent Office

Office européen des brevets

(11) Publication number: **0 222 863**
**B1**

(12) **EUROPEAN PATENT SPECIFICATION**

(45) Date of publication of patent specification: **26.09.90**

(51) Int. Cl.⁵: **H 03 D 3/00**

(21) Application number: **86903449.6**

(22) Date of filing: **12.05.86**

(86) International application number:
**PCT/GB86/00260**

(87) International publication number:
**WO 86/06894 20.11.86 Gazette 86/25**

(54) **FM FEEDBACK DEMODULATOR USING INJECTION-LOCKED OSCILLATOR.**

(30) Priority: **11.05.85 GB 8512000**

(43) Date of publication of application:
**27.05.87 Bulletin 87/22**

(45) Publication of the grant of the patent:
**26.09.90 Bulletin 90/39**

(84) Designated Contracting States:
**DE FR NL**

(56) References cited:
**US-A-2 488 584**
**US-A-4 087 756**
**US-A-4 357 580**

**RCA Review, vol. 27, no. 4, December 1966
(Princeton, US) F. LeFrak et al.: "The frequency-
modulation feedback system for the lumar-
orbiter demodulator", pages 563-576**

(73) Proprietor: **PLESSEY OVERSEAS LIMITED
Vicarage Lane
Ilford Essex IG1 4AQ (GB)**

(72) Inventor: **COWLEY, Nicholas, Paul
10 Summerhouse Road
Wroughton Wiltshire (GB)**

(74) Representative: **Lupton, Frederick
The Plessey Company plc Intellectual Property
Dept. Vicarage Lane
Ilford, Essex IG1 4AQ (GB)**

## Description

The present invention relates to improvements in demodulators for frequency modulated signals, hereinafter referred to as FM demodulators.

FM demodulators which utilise a frequency discriminator, such as a quadrature demodulator, exhibit a threshold level below which they are unable to function satisfactorily. The threshold level is the carrier signal to noise signal ratio in the FM signal to be demodulated where the noise begins to introduce characteristic FM noise into the demodulated signal. For FM video signals this characteristic FM noise can produce sparklies into the demodulated video picture, and so degrades the video quality, making it unsuitable for most applications.

For many applications, such as satellite communication systems, this level is unacceptably high and hence, threshold extension techniques have been proposed. Threshold extension is a method of extending the carrier signal to noise signal ratio into an increasingly noisy signal whilst maintaining the same quality output signal as obtained from higher carrier to noise signal ratios.

It is proposed in our copending application EP 84307428.7 (EP—A—0 143 556, published 5.6.1985) to precede the quadrature demodulator with an injection locked oscillator/divider (ILO/D) to extend the threshold. An injection locked oscillator/divider is a mixer/oscillator combination whose natural frequency, generally known as the centre frequency, is equal to or a subharmonic of the input carrier frequency. The FM signal to be demodulated is injected into the mixer input port of the device and, provided the frequency deviation of the input signal is not excessively high, an oscillator harmonic will tend to phase-lock to the FM input signal. The maximum possible deviation in the output signal from the injection locked oscillator/divider is proportional to the power of the input signal. Hence, threshold extension is obtained which is proportional to the power of the input signal.

The combination of the quadrature demodulator and injection locked divider is inherently relatively linear and is very simple in its application. However, such devices attain threshold extension at the expense of demodulated video bandwidth.

Furthermore, for certain applications, such as satellite video transmission links having wideband deviation signals, the threshold levels of both systems are not acceptable.

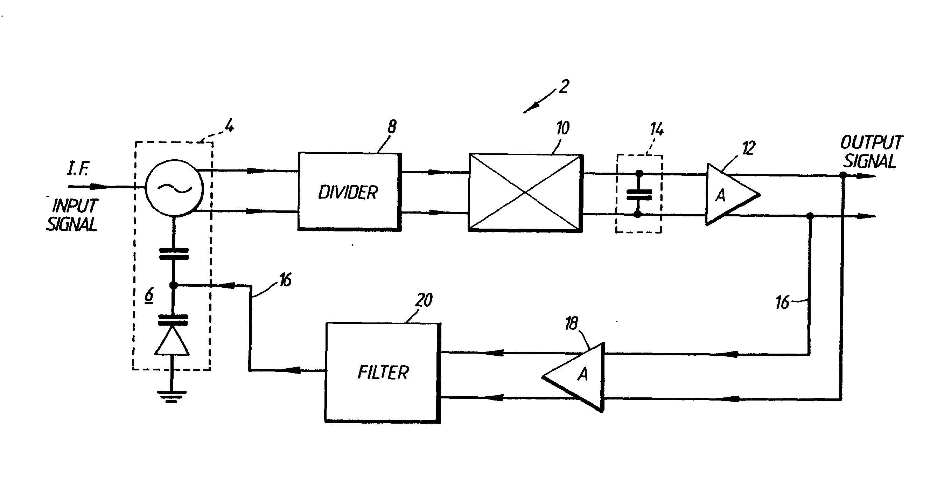

The document RCA Review Vol. 27, No. 4 "The FM feedback system for the lunar-orbiter demodulator" discloses in Figure 3 a demodulator for FM signals, the demodulator comprising a mixer and oscillator for receiving an input signal to be demodulated, a frequency discriminator for providing a demodulated output signal, and a feedback loop for affording a feedback signal, dependent upon the demodulated output signal, to the oscillator for constraining the centre frequency thereof to correspond with the frequency of the input signal.

This document deals with the problems of threshold extension in a complex system for a moon-landing system, wherein the received signal is first down-converted to 10 MHz and then up converted in said mixers to 45 MHz. Such systems are too complex and expensive for use in commercial TV systems, with which the present invention is concerned. Furthermore whilst threshold extension is achieved in the document, increased threshold extension is desirable with lower cost circuitry in the present invention.

It is an intention of the present invention to provide an FM demodulator of simple application and having improved threshold extension.

The present invention provides a demodulator for frequency modulated FM signals, the demodulator comprising a mixer and oscillator (4) for receiving an input signal to be demodulated, a frequency discriminator (10) for providing a demodulated output signal, and a feedback loop (16) for affording a feedback signal, dependent upon the output signal, to the oscillator for contraining the centre frequency thereof to correspond with the frequency of the input signal, characterised in that the mixer and oscillator are comprised in an injection locked oscillator/divider whose centre frequency is equal to or a subharmonic of the frequency of the input signal, and that the feedback signal is applied as a control voltage to a tuning circuit means (6) which is effective to alter the centre frequency.

Preferably, the frequency discriminator comprises a quadrature demodulator.

The demodulator may comprise a divider, coupled to the injection locked oscillator/divider and the frequency discriminator, for dividing the frequency of the output signals from the injection locked oscillator/divider.

Advantageously, the demodulator comprises a filter for filtering the demodulated output signals from the frequency discriminator.

Conveniently, the feedback loop comprises a loop filter for filtering the feedback signal afforded to the injection locked oscillator/divider.

In a preferred embodiment, the demodulator comprises an amplifier for amplifying the demodulated output signal.

Preferably the injection locked oscillator/divider comprises a varactor diode tuning circuit for receiving the feedback signal afforded by the feedback loop.

The feedback loop may comprise a loop amplifier for amplifying the feedback signal.

The present invention will now be described, by way of example, with reference to the accompanying drawing which illustrates a generally schematic block diagram of an improved FM demodulator.

The FM demodulator 2 comprises an injection locked oscillator/divider (ILOD) 4, having a varactor diode tuning circuit 6, for receiving an IF input signal, such as an FM modulated video signal.

The injection locked oscillator/divider 4 is coupled via a divider 8 to a frequency discriminator, such as a quadrature demodulator 10 for demodulating the IF input signal. The output of the quadrature demodulator 10 is coupled to an amplifier 12, the output of which provides the output signal from the FM demodulator 2. A filter 14 is provided for filtering the harmonics and sub-harmonics of the output signal from the quadrature demodulator 10 which lie outside the desired passband of the demodulator 2. A feedback loop 16 is provided, which comprises a loop amplifier 18 coupled to a loop filter 20, for providing a feedback signal to the varactor tuning circuit 6 of the injection locked oscillator/divider 4, which feedback signal is dependent upon the demodulated output signal from the quadrature demodulator 10. The loop filter 20 is designed to have a bandpass transfer function and whose phase shift at critical frequencies, such as the subcarrier frequencies in subcarrier television modulation type signals, is arranged to cancel the phase shift introduced by delays within the FM demodulator 2.

Typically, the subcarrier television modulation type signal is the chroma sub-carrier signal in a PAL television signal.

In operation, an IF input signal, such as an FM video signal having an IF frequency in the range of 70 to 600 MHz, is fed to the injection locked oscillator/divider 4. The centre frequency of the injection locked oscillator/divider will follow the IF frequency of the input signal and hence a signal is provided at the input of the divider 8 which corresponds to the IF input signal, or a sub-harmonic of this signal. The output signal from the divider 8 is a sub-harmonic of the IF input frequency and is fed to the quadrature demodulator 10. The divider 8 is required to ensure that the quadrature demodulator 10 receives an input signal having a frequency which is within the operating range of the device. Typically, quadrature demodulators have a maximum operating frequency of about 150 MHz. If the input signal has an IF frequency of 600 MHz the injection locked oscillator/divider 4 can be arranged to operate as a divider and produce a sub-harmonic output signal of 300 MHz frequency. The division ratio of the divider 8 can then be set at 2 to give an input signal to the quadrature demodulator of 150 MHz frequency, within the operating range of the device.

If the input signal has an IF frequency of 70 MHz, the injection locked oscillator/divider can be arranged to operate as an oscillator to provide an output signal of 70 MHz frequency. The division ratio of the divider 8 can then be set at unity or the divider can be removed from the circuit as the frequency of the output signal from the injection locked oscillator 4 is within the operating range of the quadrature demodulator 10.

The demodulated output signal from the quadrature demodulator 10 is filtered by the filter 14, and amplified by the amplifier 12 to provide the demodulated video output signal which can be displayed on a suitable display unit.

The output signal is also fed along the feedback loop 16 where it is further amplified and filtered by, respectively, the loop amplifier 18 and the loop filter 20 and passed to a varactor line in the varactor diode tuning circuit 6. The feedback signal modulates the injection locked oscillator divider 4 in a predictive sense such that its natural or centre frequency is constrained to the frequency of the incoming IF signal. This reduces errors in the output signal from the injection locked oscillator/divider 4 and so reduces the likelihood of threshold sparklies occurring in the video output. The feedback loop 16 in combination with the level of the IF input signal causes the injection locked oscillator/divider 4 to act as a tracking filter to the IF input signal. Since the lock range, that is, the effective filter bandwidth is controlled by the level of the IF input signal, the FM demodulator 2 can be arranged such that it has a narrow lock range about a tracking predicted centre frequency of the injection locked oscillator/divider 4. By effective reduction of the noise bandwidth of the IF input signal the threshold level of the FM demodulator 2 is improved.

In practice, the FM demodulator of the present invention has achieved threshold levels of 5 dB for narrowband deviation input signals and 6 dB for wideband deviation input signals; an improvement of over 2 dB when compared to known systems. With optimisation of the elements in the feedback loop the lock range can be reduced to less than twice the bandwidth of the video information in the IF signal; providing a further extension of threshold level.

**Claims**

1. A demodulator for frequency modulated FM signals, the demodulator comprising a mixer and oscillator (4) for receiving an input signal to be demodulated, a frequency discriminator (10) for providing a demodulated output signal, and a feedback loop (16) for affording a feedback signal, dependent upon the output signal, to the oscillator for contraining the centre frequency thereof to correspond with the frequency of the input signal, characterised in that the mixer and oscillator are comprised in an injection locked oscillator/divider whose centre frequency is equal to or a subharmonic of the frequency of the input signal, and that the feedback signal is applied as a control voltage to a tuning circuit means (6) which is effective to alter the centre frequency.

2. A demodulator according to claim 1 wherein the tuning circuit means (6) comprises a varactor diode tuning circuit for receiving the feedback signal afforded by the feedback loop.

3. A demodulator according to claim 1 or claim 2 wherein the frequency discriminator (10) comprises a quadrature demodulator.

4. A demodulator according to any one of claims 1, 2 or 3 comprising a divider (8), coupled to the injection locked oscillator/divider and the frequency discriminator, for dividing the frequency of the output signals from the injection locked oscillator/divider.

5. A demodulator according to any one of the preceding claims comprising a loop filter arranged in the feedback loop for filtering the feedback signal afforded to the injection locked oscillator/divider, wherein the loop filter is arranged to provide a phase shift, at subcarrier frequencies in a subcarrier television type modulation signal, which is substantially equal to the phase shift produced by propagation delays within the frequency discriminator whereby any phase shift produced by the frequency discriminator is cancelled.

**Patentansprüche**

1. Ein Demodulator für frequenzmodulierte FM-Signale, umfassend einen Mischer und Oszillator (4) zum Empfangen eines zu demodulierenden Eingangssignals, einen Frequenz-Diskriminator (10) zum Senden eines demodulierten Ausgangssignals, und eine Rückführungsschleife (16) für den Erhalt eines von dem Ausgangssignal abhängigen Rückführungssignals zu dem Oszillator, um dessen Mittenfrequenz dazu zu bringen, daß sie mit der Frequenz des Eingangssignals übereinstimmt, dadurch gekennzeichnet, daß der Mischer und der Oszillator in einem einspritzverriegelten Oszillator/Teiler enthalten sind, dessen Mittenfrequenz gleich oder subharmonisch zur Frequenz des Eingangssignals sind, und daß das Rückführungssignal als eine Steuerspannung zu einer Abstimmschaltung (6) gesendet wird, die zum Ändern der Mittenfrequenz dient.

2. Demodulator nach Anspruch 1, worin die Abstimmschaltung (6) eine Varactordioden-Abstimmschaltung zum Empfangen des von der Rückführungsschleife gesendeten Rückführungssignals umfaßt.

3. Demodulator nach Anspruch 1 oder Anspruch 2, worin der Frequenz-Diskriminator (10) einen Querdemodulator aufweist.

4. Demodulator nach einem der Ansprüche 1, 2 oder 3, umfassend einen mit dem einspritzverriegelten Oszillator/Teiler und dem Frequenz-Diskriminator gekoppelten Teiler (8) zum Teilen der Frequenz des Ausgangssignals von dem einspritzverriegelten Oszillator/Teiler.

5. Demodulator nach einem der vorhergehenden Ansprüche, umfassend einen in der Rückführungsschleife angeordneten Schleifenfilter zum Filtern des Rückführungssignals, das zu dem einspritzverriegelten Oszillator/Teiler gesendet wurde, in dem der Schleifenfilter zur Erzielung einer Phasenverschiebung bei Unterträgerfrequenzen in einem Modulationssignal des Typs eines Unterträger-Fernsehsignals dient, das im wesentlichen gleich der durch die Ausbreitungsverzögerungen innerhalb des Frequenz-Diskriminators erzeugten Phasenverschiebung ist, wodurch jede durch den Frequenz-Diskriminator erzeugte Phasenverschiebung gelöscht wird.

**Revendications**

1. Démodulateur de signaux modulés en fréquence, le démodulateur comprenant un mélangeur et oscillateur (4) destiné à recevoir un signal d'entrée à démoduler, un discriminateur de fréquence (10) destiné à transmettre un signal démodulé de sortie, et une boucle de rétroaction (16) destinée à transmettre un signal de rétroaction, qui dépend du signal de sortie, à l'oscillateur afin que la fréquence centrale de celui-ci corresponde à la fréquence du signal d'entrée, caractérisé en ce que le mélangeur et oscillateur est formé d'un oscillateur verrouillé par injection et diviseur dont la fréquence centrale est égale à la fréquence du signal d'entrée ou est un sous-harmonique de cette fréquence, et en ce que le signal de rétroaction est appliqué comme tension de commande à un circuit d'accord (6) qui peut modifier efficacement la fréquence centrale.

2. Démodulateur selon la revendication 1, dans lequel le circuit d'accord (6) est un circuit d'accord à diode à capacité variable destiné à recevoir le signal de rétroaction transmis par la boucle de rétroaction.

3. Démodulateur selon la revendication 1 ou 2, dans lequel le discriminateur de fréquence (10) est un démodulateur en quadrature.

4. Démodulateur selon l'une des revendications 1, 2 et 3, comprenant un diviseur (8) couplé à l'oscillateur verrouillé par injection et diviseur et au discriminateur de fréquence et destiné à diviser la fréquence des signaux de sortie de l'oscillateur verrouillé par injection et diviseur.

5. Démodulateur selon l'une quelconque des revendications précédentes, comprenant un filtre de boucle monté dans la boucle de rétroaction et destiné à filtrer le signal de rétroaction transmis à l'oscillateur verrouillé par injection et diviseur, le filtre de boucle étant destiné à introduire un déphasage, aux fréquences de sous-porteuse d'un signal de modulation du type de télévision à sous-porteuse, qui est pratiquement égal au déphasage produit par les retards de propagation dans le discriminateur de fréquence, si bien que tout déphasage produit dans le discriminateur de fréquence est compensé.